(19) Europäisches Patentamt
European Patent Office
Office européen des brevets

(11) **EP 4 068 342 A1**

(12) **EUROPEAN PATENT APPLICATION**

(43) Date of publication:
**05.10.2022 Bulletin 2022/40**

(21) Application number: **21305435.6**

(22) Date of filing: **02.04.2021**

(51) International Patent Classification (IPC):
**H01L 21/607** *(2006.01)*     **H01L 23/49** *(2006.01)*

(52) Cooperative Patent Classification (CPC):
(C-Sets available)
**H01L 24/48; B23K 20/004; H01L 24/85;**
H01L 24/05; H01L 24/45; H01L 2224/04042;
H01L 2224/05014; H01L 2224/05015;
H01L 2224/056; H01L 2224/45014;
H01L 2224/45015; H01L 2224/45124;
H01L 2224/45147; H01L 2224/48227;
H01L 2224/48247;                    (Cont.)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Mitsubishi Electric R&D Centre Europe B.V.
1119 NS Schiphol Rijk Amsterdam (NL)**
Designated Contracting States:
**FR**
• **Mitsubishi Electric Corporation
Tokyo 100-8310 (JP)**
Designated Contracting States:
**AL AT BE BG CH CY CZ DE DK EE ES FI GB GR
HR HU IE IS IT LI LT LU LV MC MK MT NL NO PL
PT RO RS SE SI SK SM TR**

(72) Inventors:
• **PICHON, Pierre-Yves
35708 RENNES cedex 7 (FR)**
• **BRANDELERO, Julio
35708 RENNES cedex 7 (FR)**
• **OUHAB, Merouane
35708 RENNES cedex 7 (FR)**
• **DEGRENNE, Nicolas
35708 RENNES cedex 7 (FR)**

(74) Representative: **Plasseraud IP
66, rue de la Chaussée d'Antin
75440 Paris Cedex 09 (FR)**

(54) **METHOD FOR IMPROVING THE MICROSTRUCTURE OF THE CONNECTION PORTION OF A BOND WIRE AS WELL AS THE RESULTING DEVICE**

(57)     The invention relates to producing a semiconductor chip-metal wire bond, by performing the steps of bonding a wire having a metal body to the semiconductor chip so as to connect the wire to the semiconductor chip, the bond metal having a polycrystalline microstructure, and deforming a bonding region of the metal body in contact with to the semiconductor chip, the deformed bonding region being characterized by a relative cross section

$$\varepsilon = \frac{A_0 - A_f}{A_0},$$

area change given by         where $A_f$ is a final cross section area and $A_0$ is an initial cross section area, the deformation involving an increase of a dislocation density in the microstructure of at least a portion of the bonding region.

**(Cont. next page)**

Definition of coordinate system

Section D

Section C

Section B

Metallisation / Section A

Semiconductor device

**FIG. 3 (a)**

Section D

Section C

Section B

Metallisation / Section A

Semiconductor device

**FIG. 3 (b)**

Section B and C have recrystallized

Metallisation / Section A

Semiconductor device

**FIG. 3 (c)**

(52) Cooperative Patent Classification (CPC): (Cont.)
H01L 2224/48458; H01L 2224/4851;
H01L 2224/78315; H01L 2224/78901;
H01L 2224/85205; H01L 2224/8593;
H01L 2224/85947; H01L 2224/85948

C-Sets
H01L 2224/056, H01L 2924/00014;
H01L 2224/45015, H01L 2924/2076;
H01L 2224/45124, H01L 2924/00014;
H01L 2224/45124, H01L 2924/01204;
H01L 2224/45124, H01L 2924/01205;
H01L 2224/45124, H01L 2924/01206;
H01L 2224/45147, H01L 2924/00014

**Description**

The present invention relates to an improvement of a metal-semiconductor bond.

In the prior art, the wedge bonding process is typically used to mechanically and electrically connect wires or ribbons made for example of Aluminium (Al), Copper (Cu) or Al-Cu composites (and alloys thereof) to a semiconductor chip coated with an Aluminium or Copper (or composite and alloys thereof) metallization surface.

The ultrasonic bonding process is also used to connect the other end of the wire/ribbon to a copper lead frame for electrical connection to the external circuit. The ultrasonic bonding process applies pressure to deform the wire on the metallization surface or lead frame such as obtaining conforming surfaces and subsequently introduces ultrasonic waves (frequency more than 20 kHz, typically 60 kHz or 110 kHz) to make the electrical connection. The technique of ultrasonic bonding process is described for example in document:
"Microstructural evolution of ultrasonic-bonded aluminum wires" Marian Sebastian Broil, Ute Geissler, Jan Höfer, Stefan Schmitz, Olaf Wittler, Klaus Dieter Lang, in Microelectronics Reliability 55 (2015) p. 961-968.

The combination of pressure and ultrasonic energy is necessary to:

- clean the metallization and the wire from oxide layers and impurities, and

- deform and recrystallize the wire and metallization surface, hence promoting interdiffusion of the two surface and good electrical and mechanical connection.

The general understanding is that the dynamics of deformation and recrystallization (dynamic recrystallization) is needed to obtain an electrical and mechanical connection because it causes softening and promotes deformation to obtain good matching surfaces and interdiffusion.

By "deformation" it is meant the process of changing the shape of the metallization and/or wire. Deformation occurs via generation and motion of dislocation defects which are present in the material and is accompanied with hardening of the material.

By "recrystallization" it is meant the process of forming new dislocation-free grains from the deformed material. It is generally accompanied with softening of the material and formation of high angle boundaries between grains.

By a "grain" it is meant a region of the microstructure, wherein no 2D defects result in a misorientation of more than 5° between the two regions separating the 2D defect.

By "high angle grain boundaries", it is meant thus the frontier of two grains with more than 15° misorientation, as characterized by, for example, EBSD measurements (for "Electron Backscattered Diffraction").

By "low angle grain boundaries", it is meant the frontier of two grains with a misorientation between 5° and 15°, as characterized by, for example, EBSD measurements.

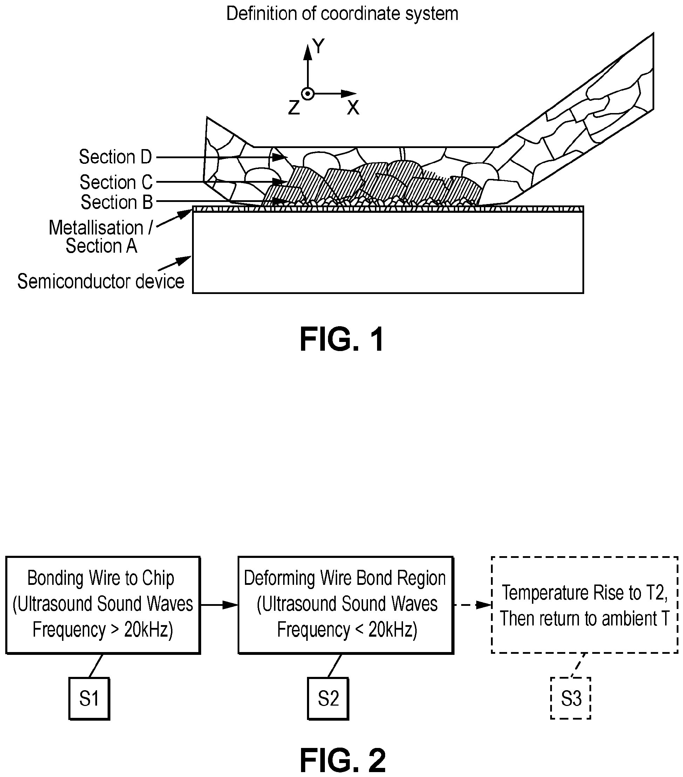

In the state of the art the ultrasonic bonding process, dynamic recrystallization process typically results in a microstructure comprised of several microstructural regions depending on the degree of cold working during ultrasonic bonding. Referring to figure 1:

- The region labelled as "section A" corresponds to the initial metallization forming a layer of typically 5μm, with grain size in the order of, or smaller than, the metallization thickness;

- The region labelled as "section B" corresponds to a recrystallized zone with small grains having a size of typically less than 10 μm, and thereby smaller than the original wire microstructure grain size which is typically between 60 and100 μm, depending on wire material selection) and with high angle grain boundaries between them. This zone B extends from the original metallization surface up to, e.g. 50μm, depending on the ultrasonic bonding parameters, and is further characterized by:

    * A preferential crystallographic orientation different than the rest of the wire material (for example 101 in the X direction).

    * A hardness lower than both the metallization and the rest of the material in section A and section C.

    * A dislocation density lower than both the metallization and the rest of the material in section A and section C.

- Section C corresponds to a deformed zone with grain size comparable with the original wire microstructure grain size or higher, but with significantly higher dislocation density structures,

- Section D is a zone not affected by the ultrasonic bonding process.

Figure 1 shows a typical example of state-of-the-art microstructure resulting from the ultrasonic bonding process, the dashed lines representing dislocation structures.

Increasing the reliability of power electronic module at higher operating temperatures (e.g., more than 170°C, or more than 200°C) is a key feature to optimize the design of power electronic converters with respect to power-to-weight ratio, cost, and efficiency.

However, it is usually observed a low reliability of the bond due to the fine grain or section B, particularly in (but not limited to) power semiconductor metallization-metallic wire/ribbon interconnections. Junction temperature swings cause cyclic thermal-mechanical stresses at the bonds. In the simplest model, the thermal mechanical stress $\sigma\_th$ at the bond increases with increasing the product of the temperature swing $\Delta Tj$ and of the difference of the Coefficient of Thermal Expansion (CTE) between the metal alloy and the semiconductor chip $\Delta CTE$ (if $\Delta Tj$ increases, then $\sigma\_th$ increases) and decreases with increasing distance from the semiconductor-metal interface. Hence the thermal mechanical stress decreases from section A to section D. The microstructural characteristics of this zone (high large angle grain boundaries area, relatively softer material) result in the preferential fracture and failure of the bond in section B.

With respect to applications where the semiconductor device is submitted to high amplitude temperature swings or high maximum junction temperature, the microstructure resulting from state-of-the-art ultrasonic bonding causes reliability issues because of the high amount of high angle grain boundaries in the recrystallized zone (region B, figure 1). The high atomic mobility of high angle grain boundaries at higher temperature cause crack propagation preferentially there due, e.g. to void formation, grain boundary sliding, etc. (known as creep-fatigue phenomenon). This effect is more pronounced for high purity wire materials exposed to temperatures higher than 0.4Tm, where Tm is the melting temperature in degrees Kelvin. For pure aluminium this corresponds to temperatures higher than 100°C, hence this effect is typically observed for $\Delta Tj>80K$ or $Tjmax>100°C$, whereas the maximum junction temperature recommended in product datasheet is typically 175°C. Although this effect is most pronounced at higher junction temperature, intergranular fracture was also observed for junction temperature as low as $Tjmax=67°C$ and temperature swings as small as $\Delta Tj=30K$ for Aluminium wire-bonds. Applications of power electronic device in the high thermal cycle amplitude region require to tailor the material such as to obtain a higher grain size, particularly in the high stress regions (region B, Figure 1), and thereby to reduce the density of possible crack path available and limit the diffusion paths available. The positive effect of increased grain size on high cycle amplitude reliability is demonstrated in the scientific literature but it is difficult to implement them at low cost in a production environment.

With respect to applications where the semiconductor device is submitted to low amplitude temperature swings or low maximum junction temperature, the microstructure resulting from state-of-the-art ultrasonic bonding causes reliability issues because of the comparatively high ductility of the recrystallized region (region B, figure 1) compared to the adjacent regions (sections A and C, figure1). The lower end for the temperature cycle range can be estimated as $\Delta Tj<00K$ or $Tjmax<120°C$ for aluminium, and more generally by $Tj<0.4Tm$, where Tm is the melting temperature in degrees Kelvin. Low cycle amplitude reliability is improved by using harder, higher strength materials. The positive effects of using higher strength wire materials on wire bond reliability is demonstrated in the literature of Aluminium wedge bonding and more recently by first assessments of Cu wedge bonding reliability. For pure copper 0.4Tm corresponds to 270°C, about 100°C above the maximum recommended junction temperature, hence for copper wire bond materials this approach is suitable for applications targeting junction temperature within the whole specified range.

As a summary of the state of the art, the recrystallization process is uncontrolled and therefore results in a non-optimized microstructure with respect to reliability. The uncontrolled nature of recrystallization in the state-of-the art ultrasonic bonding is the result of:

- the simultaneous application of pressure (to drive deformation) and ultrasonic energy (to drive recrystallization): thus, recrystallization is coupled to the deformation process,

- uncontrolled localized heating, which is a side result of the energy dissipated during the deformation process and influences the recrystallization and deformation processes.

The present invention aims to improve the situation.

To that end, it is proposed a method to produce a semiconductor chip-metal wire bond, comprising :

- S1: bonding a wire having a metal body to the semiconductor chip so as to connect the wire to the semiconductor chip, the metal body having a polycrystalline microstructure,

Wherein the method further comprises:

- S2: deforming a bonding region of the metal body in contact with the semiconductor chip, the deformed bonding region being characterized by a relative cross section area change given by $\varepsilon = \frac{A_0 - A_f}{A_0}$, where $A_f$ is a final cross section area and $A_0$ is an initial cross section area, the deformation involving an increase of a dislocation density in the microstructure of at least a portion of the bonding region.

Thanks to step S2, the hardness of the material forming the wire bond region is highly increased and can be suitable for particular applications of the semiconductor chip.

Here the word "wire" can designate a "usual" cylindrical wire, or possibly also a ribbon or more generally any flexible metallic body of a connection cable.

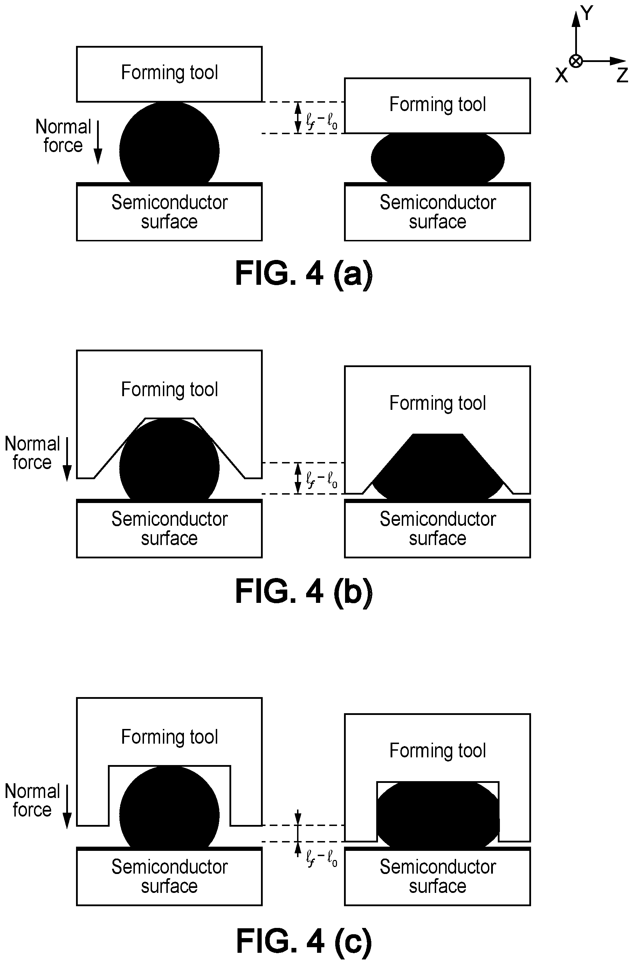

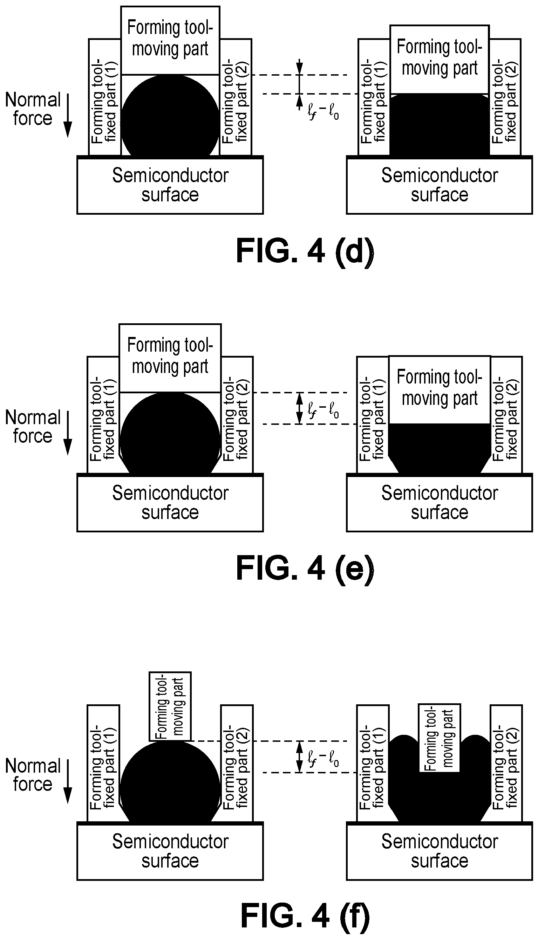

In an embodiment, step S2 is carried out by repeating successive deformations of the bonding region. S2 can be carried out for example by successively pressing the central region of the bond as shown on figure 4-c) or 4-d) in an example of embodiment.

In a particular but convenient embodiment, step S2 (and typically the successive deformations of S2 when such successive deformations are implemented) is performed by dispensing ultrasound waves at a frequency lower than 20kHz, along at least one dimension of the bond region.

Typically, the bonding S1 of the metal body to the semiconductor chip can be performed by dispensing ultrasound waves at a frequency higher than 20kHz, thereby enabling a same ultrasound waves dispensing device to perform both S1 and S2, the frequency of the ultrasound waves being changed between S1 and S2.

The ultrasound waves dispensing device can comprise thus a wedge for dispensing the ultrasound waves. This wedge can have a chosen form (among the ones presented for example in figure 4) for performing the deformation S2.

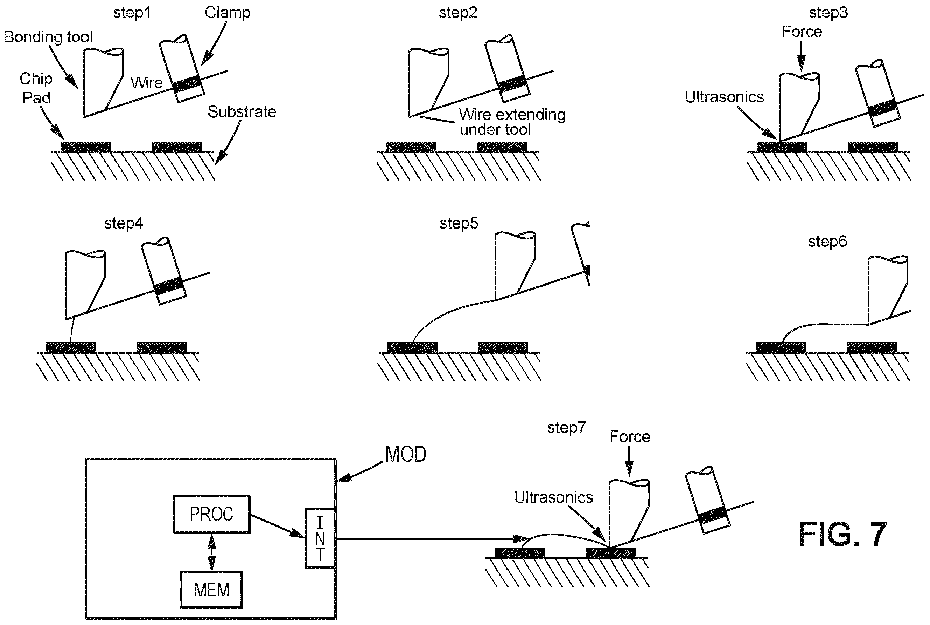

Typically, the deformation can be applied during a loop formation (as presented in figure 7), and the deformation of the bond region can be applied by a combination of a displacement of the wedge and/or of a wire clamp (as shown also in figure 7).

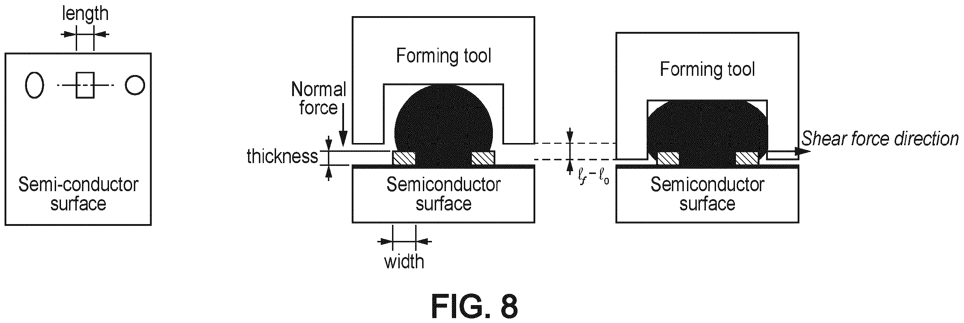

In an embodiment, a pad set can be placed before step S1 on a surface of the semiconductor chip receiving the metal body, so as to limit a lateral expansion of the metal body during the deformation S2 (as presented in figure 8).

In an embodiment where the metal body comprises Aluminium, the deformation obtained in S2 can be comprised typically between a minimum threshold of 10% and a maximum threshold of 70% (and preferably between 20% and 50%).

In an embodiment where the metal body comprises Copper, the deformation obtained in S2 can be comprised between a minimum threshold of 10% and a maximum threshold of 90% (and preferably between 30% and 80%).

II an embodiment, the method further comprises:

- S3: after S2, raising temperature at least at the bond region, from a temperature T1 to a temperature T2, and maintaining the temperature T2 for a certain time t1 and then returning to ambient temperature,

so as to decrease the dislocation density in the microstructure of at least said portion of the bonding region, and to increase a mean crystal grain size in at least one portion of said bond region compared to the microstructure of the bond region after S1.

The temperature rise of the bond can be achieved by generating heating losses in the semiconductor chip and more particularly by inputting a load current passing through the chip. The heating of the semiconductor chip can be a controlled by using advantageously a gate driver of the chip. Therefore, the control can be operated typically by a measurement of a parameter representing a junction temperature of the semiconductor chip in an example of embodiment.

For controlling the temperature rise, computer program instructions can be recorded in a memory (reference MEM of figure 7), and executed during S3 by a processing circuit (comprising a processor PROC to read and execute the instructions) for controlling operations of the semiconductor chip.

The present invention aims also at a semiconductor chip comprising a metallic wire bond fixed on a surface of the semiconductor chip by implementation of steps S1 and S2 presented above, and more particularly the metallic wire bond has then a hardness higher than 500 MPa. This hardness value can be as measured by nanoindentation technique with a tool such as a MTS DCM nano-indenter equipped with a Berkovich indent TB18193-160209 at a strain rate of $0,05$ s$^{-1}$ at an oscillation frequency of 75Hz and where the hardness is measured at an indent depth between 500nm and 700nm for example.

The present invention aims also at a semiconductor chip comprising a metallic wire bond fixed on a surface of the semiconductor chip by implementation of step S3 presented above. The metallic wire bond has then a microstructure presenting crystal grains having a mean size greater than 5 $\mu$m (and preferably greater than 10 $\mu$m, as measured typically by Electron BackScatter Diffraction (EBSD) with a grain boundary misorientation criteria of 5°).

The present invention aims also at an ultrasound waves dispensing device, comprising in particular a wedge for performing step S2 presented above.

The present invention aims also at a computer program comprising instructions for controlling the temperature rise of step S3 presented above, when such instructions are executed by a processing circuit. The invention aims also at a non transitory computer readable medium (such as the memory MEM presented in figure 7) storing such instructions.

Therefore, thanks to the embodiments presented above, it is proposed new degrees of freedom during manufacturing to improve the bond reliability and tailor the bond material properties depending on the application, by either increasing the hardness of the bond area or by increasing its grain size. Additionally, the additional steps introduced by the method presented above can be realised at low cost and with only minor modification of manufacturing equipment (such as the "same" ultrasound waves dispensing device).

More details and advantages of the invention will be understood when reading the following description of embodiments given below as examples, and will appear from the related drawings where:

Figure 1 shows a state-of-the-art microstructure example resulting from the ultrasonic bonding process, the dashed lines representing dislocation structures.

Figure 2 shows a method according to an embodiment for producing a semiconductor chip-metal wire bond.

Figure 3 shows (a) the example of state-of-the-art microstructure result from the ultrasonic bonding process (after step S1) - (b) an example of microstructure after step S2 with increased dislocation density - (c) an example of microstructure after step S3 with larger crystal grains.

Figure 4 shows examples of forming tool geometries showing cross section examples of a forming tool and of the deformed wire material (in black): (top) flat tool cross section, (middle) wedge tool cross section, (bottom) square tool cross-section.

Figure 5 shows an example of an alternative forming tool geometry.

Figure 6 are respective EBSD images showing the difference in grain size distribution for a typical Aluminum bond between applying step S1 only and step S1, then step S3 (without step S2), the thermal treatment conditions of step S3 being : rate R1=20°C/min from temperature T1=25°C to T2=175°C and then let at T2 during 96h. The pictures show EBSD data plots of the grain size, where each grain is given a colour depending on its size. The scales differ for the two images.

Figure 7 shows a typical possible sequence for ultrasonic wedge bonding of a first bond, loop formation and ultrasonic wedge bonding of a second bond.

Figure 8 show a placement of the forming tool attached on the semiconductor region: a) top view b) and c) sliced view.

The invention is both a method to create a semiconductor metallization surface-metallic wire bond with improved reliability and the thusly produced device which is then characterized by:

- A hardened bond area, specifically in region B to improve reliability for low temperature amplitude range for materials that suffer from creep-fatigue (such as Aluminium and Aluminium alloys), or on the whole specified temperature amplitude range for materials that do not significantly suffer from creep-fatigue (such as Copper Cu and Cu alloys).

Or possibly also, if step S3, is implemented:

- A significant increased average grain size and decreased high angle grain boundary area in the initially critical crack propagation zone to improve reliability against cyclic creep (section B in figure 1).

The method comprises either one (step S2) or two (steps S2 and S3) additional process steps introduced after the state-of-the-art ultrasonic bonding step S1 to control the final bond microstructure and material properties.

Referring to figure 2, the possible two additional steps are:

- A (controlled) deformation step S2, necessary to introduce dislocation defects, specifically in the initial fine-grained recrystallized zone, hence increasing the hardness there. At the end of this step the material properties are improved with respect to low temperature cycle amplitude reliability.

Then, if required by the application (high temperature cycle amplitude) or the material (e.g. Aluminium), another step S3 can be added:

- A (controlled) temperature step S3, to drive optimized recrystallization, remove the formed dislocation structures, and finally obtain a large grain size with a low area fraction of high angle grain boundaries at the high stress region, specifically in the initially fine-grained recrystallized zone, such as to improve reliability against cyclic creep failure.

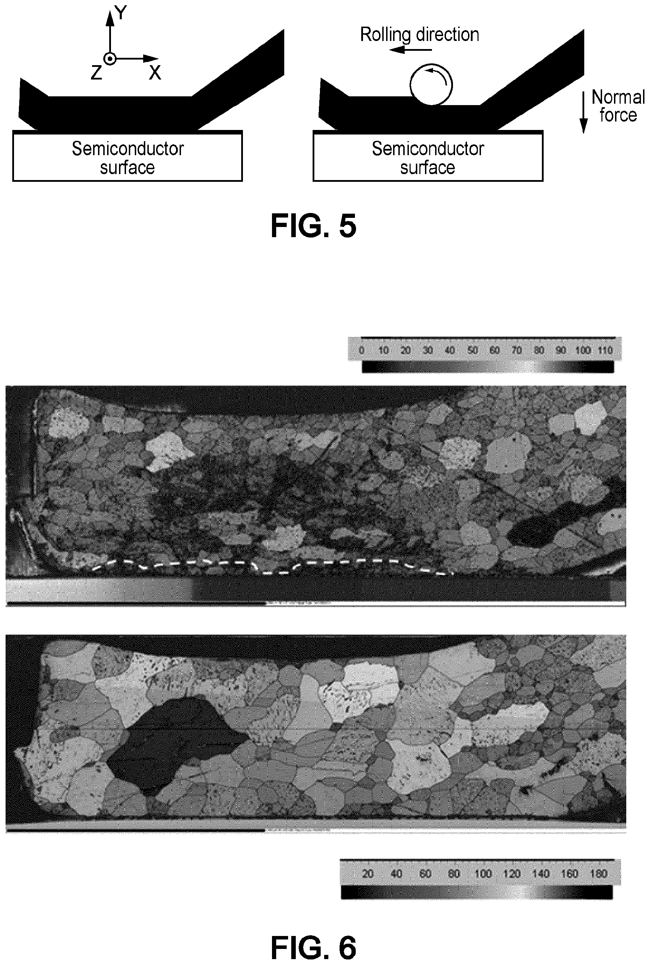

Applying the second additional step alone after state-of-the art ultrasonic bonding is also possible to reach the high grain size (as shown in figure 6), but is impractical, as thermal treatment times (several days) are incompatible with manufacturing requirements, and/or temperatures above the maximum specified values are needed. The first additional step introduces dislocation defects that significantly reduce the required time and/or temperature needed to obtain the transformation in the second step.

A cost and time-efficient implementation of the deformation step is to use the wedge bonding tool, or a slightly modified design of the wedge bonding tool for application.

A cost and time-efficient implementation of the temperature step is to generate heat losses in the semiconductor in a controlled way by using a specific gate driver. Such an implementation of the method can be done during the semiconductor device operation, preferably at the beginning of the product life, with no effect on production costs and with minor effect on product performance.

Therefore, in order to produce a semiconductor chip-metal wire bond, a method according to the present invention can comprise typically the steps of:

- S1: Connecting the semiconductor chip with a flexible metal body, using a state-of-the art bonding technology, the microstructure of the resulting bond being characterized in term of an initial grain size distribution and a mean grain size $D_i$, and an initial dislocation density distribution and an initial mean dislocation density $\rho_{d,i}$, the metal body being a wire, a ribbon or any 2D shape,

- S2: After step S1, deforming the bond region with a forming tool, the bond region being defined as the wire and/or metallization material with a microstructure (grain size, dislocation density, grain boundary type, texture) significantly different as the initial material, the deformation being characterized by a relative cross section area change $\varepsilon = \frac{A_0 - A_f}{A_0}$, ($A_f$ being the final cross section area and $A_0$ the initial cross section area) during at least one moment in step S2. The deformation can be done in one or several successive iterations at a frequency preferably lower than 20kHz, along at least one dimension of the bond region. The deformation can take place at a certain temperature T1. The microstructure of the resulting bond is thus characterized by an increased dislocation density $\rho_{d,deformed}$ in at least one portion of the bond compared to the microstructure result of step S1.

The aforesaid initial material is called also hereafter the "loop material" since it is the one not involved in the process of steps S1 to S3. This "loop material" corresponds typically to the free wire between two bond regions as typically represented as "step 7" of figure 7 commented later in the present description.

By performing step S2, the wire bond reliability is improved, particularly in low thermal cycle amplitude region, because the recrystallized zone after step S1 is hardened by step S2 conferring the wire bond material a higher hardness and strength at the area highly stressed during device operation.

As an example of embodiment, during step S2 the amount of deformation can be tuned to achieve a desired final material hardness or strength. It is for example 1%, or 10%, or 50%, or 90% It can be more than the level required to overcome the elastic response of the material, for example more than 0.2%, and less than the level resulting in failure of one of the materials of the assembly, be it the wire material, the wire-metallization interface, the metallization, the electrical isolating layer covering the semiconductor chip, or the semiconductor chip, or any other part of the assembly.

During step S2 the temperature at which the deformation takes place is critical to avoid recrystallization and/or minimize dislocation rearrangements during the deformation step (dynamic recrystallization and recovery). Higher deformation and higher temperatures (relative to the melting point), and higher purity promote dynamic recrystallization. For example, at deformation of 20% for an aluminium wire material of purity 99.99% the temperature T1 is advantageously maintained lower than 75°C, or lower than 50°C, or lower than 25°C. In another example, at deformation of 95%, for an aluminium wire material of purity better than 99.99% (for example 99.999% or 99.9999%) the temperature T1 is advantageously maintained lower than 25°C, or even lower than -70°C (liquid nitrogen) and then back to ambient temperature as temperature T2 of step S3 detailed later in the present description.

Hence it is desirable to control the temperature. Temperature control may be done by actively cooling (respectively heating) the deformation tool and extracting the heat from (respectively transferring the heat to) the deforming wire material. Active cooling (respectively heating) can be realized by state-of-the art cooling techniques, such as liquid cooling (liquid: water, glycerol, nitrogen etc...) circuitry introduced in the deformation tool, or thermoelectric cooling. Active heating can be realized by state-of-the-art active heating techniques, such as resistive heating, induction heating, laser heating, introduced in the deformation tool or applied externally. Temperature control can be introduced by state-of-the art temperature measurements and control techniques, such as thermocouple measurement, infrared optical sensor measurement or any other temperature control methods.

At the end of step S2 the dislocation density $\rho_{d,deformed}$ can be compared with that of step S1 by indirect methods such as estimating the geometrically necessary dislocation density (GND) from EBSD data using data treatment algorithms, or more direct comparison using Transmission Electron Microscope (TEM) samples comparison.

At the end of step S2 the material hardness can be compared with that of step S1 for example by a nanoindentation method. For example in high purity (4N or 5N) Aluminium bonds in section B the hardness typically increases from less than 0.5GPa, or less than 0.45 GPa, or less than 0.4 GPa after step S1, to more than 0.5 GPa, or more than 0.6 GPa, or more than 0.7 GPa after step S2.

The deformation process may be either displacement controlled, or force controlled, using deformation and/or pressure and/or force measurement gages and control systems. In case it is force controlled, the applied force should overcome the yield stress of the wire material, defined as the stress for which the deformation is 0.2%. This value depends critically on the wire material type, impurities level, and bond geometry (wire geometry, bond footprint), and prior treatment history. Hence the examples chosen here must not limit the scope of this invention. For an ultrasonic wedge bond made from a 300μm Aluminium wire of purity 4N (99.99%) and having a footprint area 2.2 10⁻⁷ m² a force reference value is, for example between 2N (N=Newton) and 100N, and preferably between 5N and 60N.

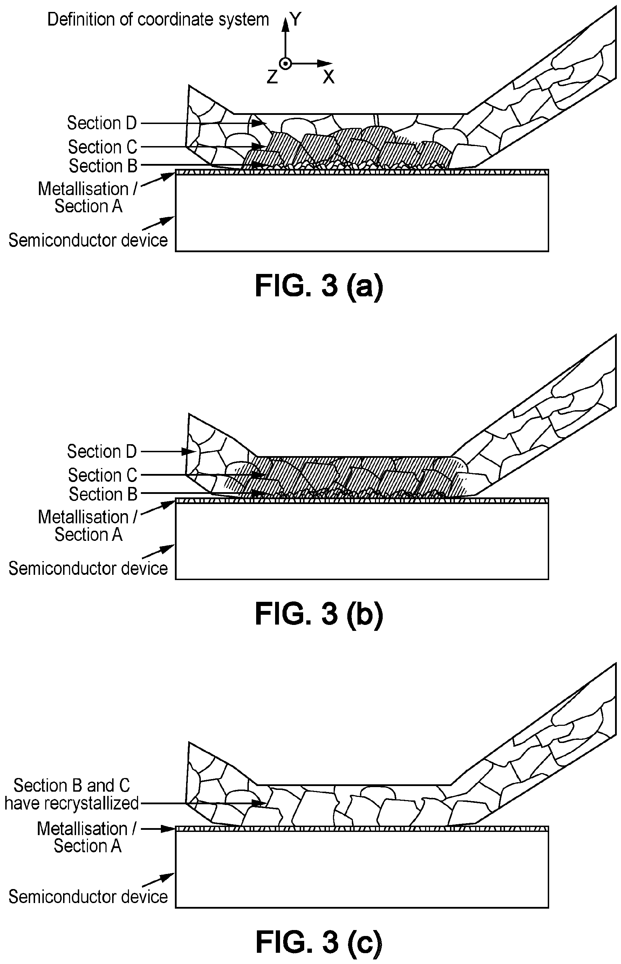

Advantageously, at the end of step S2 the aforesaid 'at least one portion of the bond' is finally the region of the microstructure with initially relatively lower hardness and dislocation density, i.e. the region B defined in figure 3-(a) presented hereafter. Thus, after step S2, the hardness and the dislocation density of region B are increased, and the reliability of the bond is increased, particularly for applications in the low cycle amplitude range, because fatigue crack propagation through region B is slower. A second advantageous feature of the increased dislocation density at region B is the increased recrystallization rate when applying step S3 presented in detail below.

Referring now to figure 3:

- (a) shows the example of state-of-the-art microstructure result from the ultrasonic bonding process, i.e. example microstructure after step S1 presented above;
- (b) shows an example of microstructure after step S2. Here, compared to after step S1, the height of the wire material is reduced by a factor $\varepsilon$, the region B has an increased dislocation density, and the volume portion of region C has increased.
- (c) shows an example microstructure after step S3 presented below. Here, compared to after step S2, the material regions B and C have recrystallized, hence reducing significantly the grain boundary area in the highly stressed region above the metallization. Dashed areas represent the regions of significantly higher dislocation density or presenting dislocation structures.

The stress field in the wire material is preferably dominated by compressive components. Thus, advantageously, a larger deformation value can be achieved compared to a stress field dominated by tensile components.

During step S2, a forming tool according to several possible options can used to deform the bond area. The tool may have a defined shape characterized by a certain internal cross section shape along the y-z plane. The internal cross section may be of any shape and is optimized to obtain a deformation field in the metal that:

- results in sufficiently low stresses so as to limit any damage to the semiconductor chip, or the metallization or the metal wire itself, particularly shear stresses at the bond interface,
- results in a controlled deformation field which promotes deformation especially at the fine grained usual recrystallized region (section B of figure 1). To illustrate the engineering compromise several tool design examples are given in figure 4a and figure 4b. These examples illustrate some tool design requirements so as :

    ◦ To minimize shear flow at the bond area, such as to avoid fracture there during the deformation step.
    ◦ To maximize pressure, and hence deformation at the center of the bond, where the recrystallized portion (microstructure region B of figure 1) is highest. In this respect a flat forming tool offers advantage over an edge or a square tool.

In figure 4a, the tool example has a flat surface applied with a vertical force in the z direction. This tool has the advantage of design simplicity. The tool example can have a wedged shape so as to limit the shear at the bond interface and the deformation in the z direction because of a force component that opposes material flow in the z direction. The tool can have finally a box shape so as to control precisely the final deformation in the z direction because material flow is constrained by the inner tool dimension.

Deformation tools may consist in several parts, for examples fixed parts and moving part, so that the functions of deforming the material and controlling the shape are separated. The tool may consist of at least one part moving during the deformation process and at least one part not moving during the deformation process (written as 'fixed part (1)' and 'fixed part (2)' in figure 4).

For example, the tool can consist in three parts:

- one part moving during the deformation process and
- two parts not moving during the deformation process (labelled as 'fixed part (1)' and 'fixed part (2)' in figure 4). This tool has the advantage that no shear force is applied at the sides of the bond, and of limiting the shear deformation at the wire-metallization contact.

The material flow is not constrained by the shape of the deformation tool. This tool ((d) for example) has the advantage that no shear force is applied at the sides of the bond, that virtually no shear deformation occurs at the wire-metallization contact, and that higher pressure can be applied at specific regions of the material, e.g. the centre of the bond as shown in this example. Alternatively, the moving part may apply pressure at the edges of the bond, or more generally where the highest stress concentration occurs during thermal-mechanical cycles.

Alternatively, the deformation tool may consist in one or several rotating cylinders that roll over a surface of the wire material close to the bond while applying a pressure to drive the deformation process (as shown on figure 4b).

The deformation tool may consist in one or several materials with different mechanical properties, to control the distribution of stresses on the bond, and hence the deformation. A combination of high modulus and low modulus material can be used. High modulus materials are typically metals and ceramics, and low modulus material are typically rubbers, polymers. The soft material may advantageously recover its shape after step S2, ensuring process reproducibility. The soft material is used preferably at regions where no, or limited shear occurs between the deforming bond and the soft material, to limit wear. The soft material may be positioned in the tool such as it is not in direct contact with the deforming bond material.

Hard materials may be used to limit the tool or tool part wear, particularly at region where shear friction between the tool and the material occur. Hence hard materials may also be used as coatings of surface layers to protect the forming tool from wear. Examples of hard materials are silicon carbide, tungsten carbide, tantalum carbide or any refractory metal carbide, silicon nitride, aluminium nitride, hardened steel, agate.

Figure 4 shows examples of forming tool geometries in the y-z plane (in the reference system definition of figure 1) showing the cross section of the forming tool and of the deformed wire material (black): (top) flat tool cross section, (middle) wedge tool cross section, (bottom) square tool cross-section.

Figure 5 shows an example of forming tool geometries in the x-y plane (reference system definition of figure 1).

The deformation in step S2 may occur in a single step. Alternatively, the deformation in step S2 occurs in *n* successive steps, i.e. by accumulating deformation at each step, with a single tool or with several tools as shown for examples in figures 4 and 5. In this case the total deformation is defined as the sum of the *i* individual deformation steps:

$$\varepsilon_{tot} = \sum_{i=1}^{n} \varepsilon_i$$

Advantageously, for a given total deformation the total shear strain on the bond surface is lower than if the deformation was done in one step, and the bond does not fracture during the deformation. Note that in this case the final shape is not necessarily different than the shape prior to the deformation, for example if a different tool and/or deformation direction is applied at each successive step such as to cancel the deformation resulting to the previous step. More specifically, the several successive steps are executed at a frequency lower than 1kHz and advantageously the heat generated by the energy dissipated during successive deformations do not increase the temperature of the bond significantly. Another advantage in operating the deformation at a frequency less than 20kHz, preferably less than 1 kHz is that the material does not soften dynamically, and the hardness and the dislocation density are increased.

The invention is not limited to the above-mentioned examples and mechanisms. Another mechanism that is beneficial to the increased device reliability is the recrystallization of the bond material during the module operation, resulting in higher grain size, and reduced grain boundary area at the highly stressed region close to the metallization. This mechanism increases the bond reliability in the high temperature cycle range by reducing the crack propagation through large angle grain boundaries. Recrystallization occurs spontaneously as the result of exposure to sufficiently high temperatures during operation at the end user. Advantageously, recrystallization is significantly faster than if step S2 was not applied, because the recrystallization process is significantly faster, due to the higher driving force for recrystallization. Thus, there is an added benefit of increased reliability because the lower grain boundary area is reached earlier in the product life than if step S2 was not applied.

Moreover, in an embodiment, Step S1 can be applied using ultrasonic wedge bonding equipment, with a frequency of the ultrasounds of more than 20 kHz. Then, step S2 can be applied, as described above.

Thus, no or minor modifications of the current bonding process for step S1 is required, compared to the state-of-the-art bonding method for power electronic applications, and the implementation of step S1 is readily available in production environments.

Typical ultrasonic wedge bonding equipment for power electronic applications operate at a frequency of 60 kHz or 110 kHz and are readily available in power electronic device production environments. This step S1 consists in the standard, state-of-the-art ultrasonic wedge bonding process. It is proposed thus here to add step S2, hence resulting in easier integration in a production environment. Critically, when step S2 consists in several successive deformations, the deformation frequency in step S2 is not necessarily in the ultrasonic range. The frequency of the several successive deformation steps is less than 20kHz which is the commonly accepted lower end limit for the ultrasonic frequency range, and hence step S2 is clearly distinct of step S1 as the several successive steps are not part of the ultrasonic bonding step.

Referring to figure 2 again, step S3 is implemented after step S2 and consists on rising the temperature at a minimum speed R1, at least at the bond region, from temperature T1 (for example the temperature after step S2) to a higher temperature T2, then maintaining the temperature T2 for a certain time t1 and then returning to ambient temperature. The microstructure of the resulting bond presents thus a decreased dislocation density $\rho_{d,f}$ in at least one portion of the bond compared to the microstructure result of step S2, and an increased mean grain size $D_f$ in at least one portion of the bond compared to the microstructure result of step S1.

Thus, the wire bond reliability is improved, particularly in high thermal cycle amplitude region. Because the microstructure of the bond is recrystallized in a controlled way, it finally has larger recrystallized grains, with a lower proportion of high angle grain boundaries compared to the microstructure resulting from the state-of-the-art methods. Additionally, the recrystallization process is significantly faster than if step S2 was not applied, because of the higher driving force for recrystallization after step S2 compared to after step S1.

Therefore, an optimum recrystallization and a globally optimized microstructure can be reached before the product is used. In contrast, if step S3 is not applied, recrystallization may occur during product usage, but not in an optimal fashion, because other processes can compete (crack propagation, grain refinement due to thermal-mechanical stresses, recovery). Hence advantageously, the introduction of step S3 provides the added benefit of increased reliability from the beginning of the product life.

During step S3 the temperature is increased from T1 to T2 in order to recrystallize the material. The rate R1 at which the temperature is increased can be critical because at intermediate values between T1 and T2 the dislocation density may decrease from $\rho_{d,deformed}$ due to dislocation rearrangements and annihilations, and the recrystallization may later be compromised when attaining temperature T2. For example, R1 is preferably more than 100°C/min.

The temperature T2 must be above the critical temperature required for recrystallization, but provided this is the case, the temperature is not critical for the final microstructure. For example, at prior deformation 20% during step S2, T2 is preferably more than 140°C for Aluminium purity of 99.99%. In another example, at prior deformation of 95% during step S2, for an aluminium wire material of purity better than 99.99% (for example 99.999% or 99.9999%) the temperature T2 is preferably higher than 50°C, or preferably higher than 100°C.

Hence for the two examples mentioned above, higher purity materials are preferred (4N or 5N for Al or Cu) since:

- Precipitated impurities may act as nucleation centres for recrystallized grains and hence reduce the final grain size,
- Dissolved and precipitated impurities may reduce the grain boundary and dislocation mobilities and hence slow down the recrystallization process.

Higher temperature may be preferred for productivity since this will quicken the recrystallization process. On the other hand the temperature T2 is preferably not too high to avoid damaging neighbouring components and/or material due to the imposed thermal-mechanical stress. Hence T2 is preferably lower than the maximum rated value in the device datasheet, for example 175°C for a standard industrial IGBT module (for "Insulated Gate Bipolar Transistor") or possibly also a diode or a MOSFET.

The time-temperature profile may be controlled using state-of-the-art temperature control technologies, including liquid cooling (liquid: water, or water plus additives, glycerol, liquid nitrogen, oil etc.) active heating technologies, including an annealing or tempering oven, local induction heating, local laser heating, resistive heating, active loss generation in the semi-conductor device, etc. The heat may be transferred from the heat source to the wire bond by means of conduction, and/or convection and/or radiation.

The method for performing steps S1, S2, S3 can be differentiated by the state-of-the-art method by measurements of the grain size, where the grain size at 10$\mu$m above the metallization:

- is more than 10$\mu$m, preferably more than 50$\mu$m, or
- is higher than that in the region unaffected by the deformation (e.g. in the loop area of the wire), for example 10% higher, or preferably 50%.

The method gives significant advantage against directly apply step S3 after step S1, because the recrystallization process is significantly faster and controlled. For example, figure 6 shows the difference in grain size distribution for a typical Aluminum bond (purity level better than 99.9%) between applying step S1 only and step S1, then step S3 (without step S2). After step S1 the microstructure is typical of the state-of-the-art and contains a small grain region B (zone B is highlighted in figure 6 as the region below the white line). After step S1, then step S3 (without step S2) the fine grain structure (region B) is removed, and the grain size is increased, but thermal treatment conditions that seriously affects productivity are needed. For example, the following thermal treatment conditions are suitable: T2>145°C and t1>96 hours (for example, T2=175°C AND t1=241 hours): such thermal treatment conditions require specific stock logistics and added energy costs. In contrary, applying step S2 significantly reduces the time t1 and energy required to achieve a similar result as shown in the bottom of figure 6, because the increased dislocation density introduced by step S2 increases the thermodynamic force for recrystallization.

This process is not limited by the above-mentioned examples and mechanisms. For example, the increased reliability of the wire-bond may be provided by impurities precipitates or alloying elements precipitates that form as the result of the thermal treatment of step S3. For example, such precipitates can contain Aluminium and Copper in significant portion (for example at least 1wt% or each components). The precipitation of precipitates may participate to the increased reliability via one or several of the following mechanisms: increased creep resistance, increased oxidation resistance, increased strength, increased hardness.

Preferably, the deformation $\varepsilon$ during step S2 is bounded by two values $\varepsilon_{low}$ and $\varepsilon_{high}$, such that:

$$\varepsilon_{low} < \varepsilon < \varepsilon_{high}$$

Thus, the minimum critical amount of dislocation necessary for recrystallization to happen is introduced in the microstructure, particularly in the initially recrystallized zone B, and the finally recrystallized material grain size is larger than the grain size in the initially recrystallized zone B.

Indeed, a critical density of dislocations is required to later initiate recrystallization. In case too low deformation is introduced in step S2, no recrystallization can take place later in the subsequent thermal treatment. Instead, typically only dislocation rearrangements can take place in structures such as e.g. subgrain boundaries. Hence there is need of a minimum amount of dislocation density to be introduced, at least in the part of the material to be recrystallized. The related necessary minimum deformation needed for recrystallization depends on the geometry of the deformation tool and the material properties, such as it is not possible to give an absolute number for $\varepsilon_{low}$ that encompasses the range of wire and metallization composition options. The material properties are critical, and $\varepsilon_{low}$ will be typically influenced by the concentration of dissolved impurities or alloying elements, by the distribution and size of precipitated impurities or alloying elements. For the sake of giving an example, the $\varepsilon_{low}$ value should be preferably 20% for 99.99% purity aluminium and should be preferably 10% for 99.999% purity aluminium.

In the other hand it is also well accepted in general literature of recrystallization that higher deformation levels will give smaller recrystallized grains after the subsequent thermal treatment. In the simplest model, the theoretical basis of this relation is that the stored energy upon deformation $E_D$ is proportional to the dislocation density, i.e.:

$$E_D \propto \rho_{d,deformed} \propto \varepsilon$$

The stored energy is converted into grain boundary energy $E_{GB}$ which is inversely proportional to the final recrystallized grain size $D_f$:

$$E_{GB} \propto 1/D_f$$

Hence full conversion of the stored internal energy (in the form of dislocations) into grain boundaries ($E_D = E_{GB}$) gives $D_f \propto 1/\varepsilon$.

$\varepsilon_{high}$ depends critically on the tool shape, and on material properties, the type and concentration of dissolved and/or precipitated alloying elements or impurities. To determine $\varepsilon_{high}$ and determine a process window $\varepsilon_{low} < \varepsilon < \varepsilon_{high}$ as set of experiments, it can be carried out a calibration with actual measurement of the final grain size $D_f$ as a function of the deformation amount $\varepsilon$, and the optimum amount of deformation can be defined. For example, $\varepsilon_{high}$ = 100%, or preferably $\varepsilon_{high}$ = 50%.

In an embodiment, the forming tool is the wedge of the ultrasonic bonding equipment itself.

Thus, no additional equipment is needed to apply the method and no additional process step is needed. Hence manufacturing investment costs and productivity are virtually not influenced by its implementation.

For example step S2 is applied after the step S1 using the same standard tool as supplied by ultrasonic bonding equipment manufacturer, and the process step S2 is added after the end of the state-of-the-art ultrasonic process, where the ultrasonic energy is switched off and the where the wedge applies an additional deformation to the state-of-the art bond (as presented typically in the middle of figure 3). The process may be either displacement controlled, or pressure controlled, using state of the art displacement and/or pressure and/or force measurement gages and control systems. For example, step S1 takes between 50 and 300 ms for Aluminium wedge bonding or between 100 and 600 ms for Copper wedge bonding, while step S2 takes 50% of the time required for bonding, or 10% of the time required for bonding, and the productivity of the method is 66%, or 91%, respectively, compared to that of the state-of-the art method.

In another example, minor modifications to the standard ultrasonic bonding wedge tool to comply to the requirements of both step S1 and step S2. Advantageously, the tool is optimized and the overall process window for the combination of step S1 and step S2 in increased, resulting in a more robust process.

In an embodiment, the deformation on the bond region is applied by a combination of the displacements of the wedge and/or a wire clamp of the tool, and the deformation is applied during loop formation.

Thus, no additional equipment is needed to apply the method and no additional process step is needed. The deformation is applied at the most stressed area of the bond. Hence initial crack propagation is slower, and the reliability is increased.

For example, during loop formation (steps 4 and 5 in Figure 7), the wedge bonding tool is moved and/or the clamp is controlled so as to apply a deformation at the last formed bond (bond formed in step 3 in figure 7), for example by a twisting motion, or by a translation motion in the x, or y or z plane, or by applying a pulling force, or by applying a pushing force, or by applying any combination of such events, the events being single events or repetitive events. For example, the wedge bonding tool is applying upwards/downwards translation motion during step 4 and/or step 5 of figure 7, resulting in cyclic deformation at the edge of the previously made bond, accumulation of dislocation in the material there, and cold-work hardening. This method has the advantage that the deformation is applied at the region of the bond that is the most highly stressed during device operation.

In an embodiment, the temperature rise of the bond is achieved by a controlled heating of the semiconductor device using a load current together with the on-state resistance of the device. This allows to generate an amount of heating losses, which can be controlled by using a gate driver, to control the chip junction temperature. It is possible also to use a passive thermal load to adjust the bond temperature using a temperature-controlled hotplate or a climatic chamber (environmental chamber). The bond temperature profile can also be achieved indeed, using a passive thermal load using a hotplate or a climatic chamber in an alternative embodiment.

Thus, no additional manufacturing step is needed to apply the thermal treatment, and there are no additional manufacturing costs related to the method.

For example, the temperature-time profile can be applied by a method where one of several parallel dies of a power semiconductor module is submitted to a leakage current, where the temperature of the semiconductor junction is measured using a thermal-sensitive electrical parameter, and where the switching pattern of the semiconductor device is controlled according to the temperature reference.

In an embodiment, the controlled heating procedure is recorded in a memory during the semiconductor chip production, and scheduled according to a predefined criterion to implement step S3. The controlled heating procedure can be executed during an operation of the chip.

Thus, advantageously the execution of the method does not cost additional time during manufacturing.

For example, the heating sequence of step S3 is recorded in a memory MEM (shown for illustration purpose on the bottom of figure 7) of a processing circuit (comprising a processor PROC) of a power module MOD connected to the chip through an interface INT, and the method is then executed according to a schedule that depends on the chip product application (i.e. during operation by an end user, or during dead times at the end user).

In an embodiment, a forming tool or structure is attached on the semiconductor metallization, at least one portion of the structure being placed under the wire bonding region prior to wire bonding formation of step S1, as shown in figure 8.

Thus, the bonding region between the wire and the metallization is concentrated only at the centre of the wire, hence removing the shear force on the section B during the deformation with a forming tool applying force at the top of the wire.

For example, a polymer can be deposited and/or attached on the metallization surface before the bonding process (step S1) in the regions where the wire will be attached on the semiconductor metallization. A screen-printing technique can be used to attach the polymer on the semiconductor metallization. A solder resister polymer can be used.

A structure with a width of 50µm can cover the semiconductor metallization with a square/round/oval shape with a thickness of 20-100µm. These dimensions are compatible with the wire-bonding machine resolution that is typically 1µm. The polymer is chosen to resist to the ultrasonic force applied during the wire bonding (step S1) and to the shear force applied during the wire deformation (step S2).

The length of the structure can be smaller or bigger than the top forming tool. Advantageous, the bigger length of the structure can act to protect the forming tool to touch the semiconductor metallization. At least one part of the structure is placed under the wire bonding.

## Claims

1. A method to produce a semiconductor chip-metal wire bond, comprising :

   - S1: bonding a wire having a metal body to the semiconductor chip so as to connect the wire to the semiconductor chip, the metal body having a polycrystalline microstructure,

   Wherein the method further comprises:

   - S2: deforming a bonding region of the metal body in contact with the semiconductor chip, the deformed bonding region being **characterized by** a relative cross section area change given by $\varepsilon = \frac{A_0 - A_f}{A_0}$, where $A_f$ is a final cross section area and $A_0$ is an initial cross section area, the deformation involving an increase of a dislocation density in the microstructure of at least a portion of the bonding region.

2. The method of claim 1, wherein S2 is carried out by repeating successive deformations of the bonding region.

3. The method according to any one of claims 1 and 2, wherein S2 is performed by dispensing ultrasound waves at a frequency lower than 20kHz, along at least one dimension of the bond region.

4. The method of claim 3, wherein the bonding S1 of the metal body to the semiconductor chip is performed by dispensing ultrasound waves at a frequency higher than 20kHz, thereby enabling a same ultrasound waves dispensing device to perform both S1 and S2, the frequency of the ultrasound waves being changed between S1 and S2.

5. The method of claim 4, wherein the ultrasound waves dispensing device comprises a wedge for dispensing the ultrasound waves, said wedge having a chosen form for performing the deformation S2.

6. The method of claim 5, wherein the deformation is applied during a loop formation, and the deformation on the bond region is applied by a combination of a displacement of the wedge and/or of a wire clamp.

7. The method according to any one of the preceding claims, wherein a pad set is placed before S1 on a surface of the semiconductor chip receiving the metal body, so as to limit a lateral expansion of the metal body during the deformation S2.

8. The method according to any one of the preceding claims, wherein the metal body comprises Aluminium and the deformation obtained in S2 is comprised between a minimum threshold of 10% and a maximum threshold of 70%.

9. The method according to any one of claims 1 to 7, wherein the metal body comprises Copper and the deformation obtained in S2 is comprised between a minimum threshold of 10% and a maximum threshold of 90%.

10. The method according to anyone of the preceding claims, further comprising:

    - S3: after S2, raising temperature at least at the bond region, from a temperature T1 to a temperature T2, and maintaining the temperature T2 for a certain time t1 and then returning to ambient temperature,

    so as to decrease the dislocation density in the microstructure of at least said portion of the bonding region, and to increase a mean crystal grain size in at least one portion of said bond region compared to the microstructure of the bond region after S1.

11. The method of claim 10, wherein the temperature rise of the bond is achieved by generating heating losses in the semiconductor chip by inputting a load current passing through the chip, said temperature rise being controlled by using a gate driver and measuring a parameter representing thereby a junction temperature of the semiconductor chip.

12. The method according to any one of claims 10 and 11, wherein computer program instructions for controlling the temperature rise S3 are recorded in a memory, and executed during S3 by a processing circuit controlling operations of the semiconductor chip.

13. A semiconductor chip comprising a metallic wire bond fixed on a surface of said semiconductor chip by implementation of the method according to any one of claims 1 to 9, wherein the metallic wire bond has a hardness higher than 500 MPa.

14. A semiconductor chip comprising a metallic wire bond fixed on a surface of said semiconductor chip by implementation of the method according to any one of claims 10 to 12, wherein the metallic wire bond has a microstructure presenting crystal grains having a mean size greater than 5 $\mu$m.

15. An ultrasound waves dispensing device comprising a wedge for performing the method according to any one of claims 3 to 6.

16. Computer program comprising instructions for controlling the temperature rise of the method according to any one of claims 10 to 12 when such instructions are executed by a processing circuit.

Definition of coordinate system

**FIG. 1**

**FIG. 2**

Definition of coordinate system

Section D

Section C

Section B

Metallisation /
Section A

Semiconductor device

## FIG. 3 (a)

Section D

Section C

Section B

Metallisation /
Section A

Semiconductor device

## FIG. 3 (b)

Section B and C
have recrystallized

Metallisation /
Section A

Semiconductor device

## FIG. 3 (c)

FIG. 4 (a)

FIG. 4 (b)

FIG. 4 (c)

FIG. 4 (d)

FIG. 4 (e)

FIG. 4 (f)

**FIG. 5**

**FIG. 6**

FIG. 7

length

Semi-conductor surface

Forming tool

Normal force

thickness

Semiconductor surface

width

Forming tool

$\ell_f - \ell_0$

Shear force direction

Semiconductor surface

**FIG. 8**

EP 4 068 342 A1

Europäisches
Patentamt

European
Patent Office

Office européen
des brevets

# EUROPEAN SEARCH REPORT

Application Number

EP 21 30 5435

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2015 056426 A (TOSHIBA CORP) 23 March 2015 (2015-03-23) * paragraphs [0015] - [0034]; figures 1(A), 1(B), 3(A), 3(B), 4(A)-4(D) * | 1-16 | INV. H01L21/607 H01L23/49 |
| T | Anonymous: "What is ultrasonic? - Herrmann Ultraschall", , 24 September 2020 (2020-09-24), XP055849149, Retrieved from the Internet: URL:https://web.archive.org/web/2020092418 3749/https://www.herrmannultraschall.com/e n/ultrasonic-welding-basics/ultrasonic-bas ics/what-is-ultrasonic/ [retrieved on 2021-10-07] * the whole document * | | |
| A | JP H09 283551 A (TOSHIBA CORP) 31 October 1997 (1997-10-31) * paragraphs [0020] - [0037], [0045], [0049]; figures 4(a)-4(d) * | 1-16 | |
| A | JP H07 135234 A (HITACHI LTD) 23 May 1995 (1995-05-23) * paragraphs [0011] - [0016]; figure 1 * | 1-16 | TECHNICAL FIELDS SEARCHED (IPC) H01L |

The present search report has been drawn up for all claims

| Place of search | Date of completion of the search | Examiner |
|---|---|---|
| Munich | 12 November 2021 | Ahlstedt, Mattias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**EP 4 068 342 A1**

## ANNEX TO THE EUROPEAN SEARCH REPORT
## ON EUROPEAN PATENT APPLICATION NO.

EP 21 30 5435

This annex lists the patent family members relating to the patent documents cited in the above-mentioned European search report.
The members are as contained in the European Patent Office EDP file on
The European Patent Office is in no way liable for these particulars which are merely given for the purpose of information.

12-11-2021

| Patent document cited in search report | | Publication date | Patent family member(s) | | Publication date |
|---|---|---|---|---|---|
| JP 2015056426 | A | 23-03-2015 | CN | 104425311 A | 18-03-2015 |
| | | | JP | 2015056426 A | 23-03-2015 |
| | | | TW | 201511148 A | 16-03-2015 |
| JP H09283551 | A | 31-10-1997 | JP | 3609530 B2 | 12-01-2005 |
| | | | JP | H09283551 A | 31-10-1997 |
| JP H07135234 | A | 23-05-1995 | NONE | | |

EPO FORM P0459

For more details about this annex : see Official Journal of the European Patent Office, No. 12/82

22

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MARIAN SEBASTIAN BROIL ; UTE GEISSLER ; JAN HÖFER ; STEFAN SCHMITZ ; OLAF WITTLER ; KLAUS DIETER LANG.** Microstructural evolution of ultrasonic-bonded aluminum wires. *Microelectronics Reliability,* 2015, vol. 55, 961-968